(19) Europäisches Patentamt / European Patent Office / Office européen des brevets

(11) **EP 4 156 480 A1**

(12) **EUROPEAN PATENT APPLICATION**
published in accordance with Art. 153(4) EPC

(43) Date of publication:
**29.03.2023 Bulletin 2023/13**

(21) Application number: **21807658.6**

(22) Date of filing: **17.05.2021**

(51) International Patent Classification (IPC):
*H02M 1/00* (2006.01)          *H05K 7/20* (2006.01)

(52) Cooperative Patent Classification (CPC):
**H02M 1/00; H05K 7/20**

(86) International application number:
**PCT/CN2021/094057**

(87) International publication number:
**WO 2021/233241 (25.11.2021 Gazette 2021/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.05.2020 CN 202020837107 U**

(71) Applicant: **Sungrow Power Supply Co., Ltd.
Hefei, Anhui 230088 (CN)**

(72) Inventors:
  • **ZHUANG, Jiacai
    Hefei, Anhui 230088 (CN)**
  • **LI, Xuan
    Hefei, Anhui 230088 (CN)**
  • **YU, Anbo
    Hefei, Anhui 230088 (CN)**

  • **SHAO, Keke
    Hefei, Anhui 230088 (CN)**
  • **QIN, Long
    Hefei, Anhui 230088 (CN)**
  • **LUO, Liyan
    Hefei, Anhui 230088 (CN)**
  • **YAO, Jubiao
    Hefei, Anhui 230088 (CN)**
  • **WANG, Yang
    Hefei, Anhui 230088 (CN)**
  • **CHEN, Chao
    Hefei, Anhui 230088 (CN)**
  • **SUN, Yafei
    Hefei, Anhui 230088 (CN)**

(74) Representative: **Biallo, Dario et al
Barzanò & Zanardo Milano S.p.A.
Via Borgonuovo, 10
20121 Milano (IT)**

(54) **POWER CONVERSION APPARATUS**

(57) The present application provides a power conversion apparatus. An additional heat capacity apparatus thereof is connected to a heating body by means of a low-heat-resistance channel, and the heat capacity of the heating body is increased, so that a temperature rise rate of the heating body can be reduced when the temperature of the heating body rapidly rises due to large transient loss, thereby lowering the temperature of the heating body at the end of the short-time peak working condition, and ensuring the reliability of a device. Moreover, a high-performance switch tube or more switch tubes connected in parallel are not required to be used as in the prior art, so that the size and the weight of the system are reduced, and the costs are saved.

Figure 5

## Description

The present application claims the priority to Chinese Patent Application No. 202020837107.2, titled "POWER CONVERSION APPARATUS", filed on May 19, 2020 with the China National Intellectual Property Administration, which is incorporated herein by reference in its entirety.

## FIELD

The present disclosure relates to the technical field of heat dissipation in power electronics, and in particular to a power conversion apparatus.

## BACKGROUND

In various application scenarios, a system not only requires a power conversion apparatus to meet a rated condition, but also requires the power conversion apparatus to provide an output capacity several times higher than a peak in the rated condition in a short period of time. In this case, loss of a heating element in the power conversion apparatus increases exponentially, resulting in a great impact on devices such as a power semiconductor device in the power conversion apparatus .

The power semiconductor device, for example, a wafer, is small in size, and is to be industrially packaged in order to be made into a finished product, thus the finished product is also small in size. In addition, in an electrical apparatus, the power semiconductor device is isolated from a heat dissipation device by an insulating material for the sake of electrical insulation, and the insulating material generally has a poor thermal conductivity. Therefore, a great loss of the power semiconductor device in a short period of time inevitably results in a sharp rise in a temperature of the power semiconductor device, greatly impacting the power semiconductor device and further reducing operation reliability of the system.

At present, in order to solve the above problems, a switch transistor with high performance is generally adopted or multiple switch transistors are connected in parallel to reduce power consumption at the peak, thereby reducing a rate at which the temperature of the power semiconductor device rises. Alternatively, the insulating material is replaced with a material of a high thermal conductivity, such as an aluminum substrate and a thermally conductive silicone grease, to speed up heat transfer from the power semiconductor device to the heat dissipation device. Alternatively, a heat dissipation device with a high heat dissipation capacity may be adopted to reduce the temperature of the power conversion apparatus itself.

However, there is a problem that the system is large in size and weight, and has high costs existing in all of the above existing technical solutions.

## SUMMARY

In view of this, a power conversion apparatus is provided according to an embodiment of the present disclosure, to solve the problem existing in the conventional technology that the system is large in size and weight, and has high costs.

To achieve the above object, the following technical solutions are provided according to embodiments of the present disclosure.

A power conversion apparatus is provided according to the present disclosure. The power conversion apparatus includes: a low thermal resistance path, a high thermal resistance path, a heatsink, an additional high heat capacity device, and at least one heating element. The additional high heat capacity device is connected to the at least one heating element via the low thermal resistance path. The heatsink is connected to the at least one heating element via the high thermal resistance path.

In an embodiment, the low thermal resistance path is made of one kind of metal or multiple kinds of metal.

In an embodiment, the additional high heat capacity device is made of metal.

In an embodiment, the additional high heat capacity device is made of copper or aluminum.

In an embodiment, the additional high heat capacity device is in a shape of a strip or a block.

In an embodiment, the additional high heat capacity device is arranged around the at least one heating element, or the additional high heat capacity device is arranged to straddle the at least one heating element.

In an embodiment, each of the at least one heating element includes a power device chip arranged on a chip lead frame.

In an embodiment, the low thermal resistance path is formed by a surface metal of a PCB and solder for the surface metal. Multiple heating elements form a power conversion circuit on the PCB.

In an embodiment, the power conversion circuit is an ACDC conversion circuit, a DCAC conversion circuit, a DCDC conversion circuit or an ACAC conversion circuit.

In an embodiment, the high thermal resistance path includes at least one insulating layer.

In the power conversion apparatus according to the present disclosure, the additional high heat capacity device is connected to the heating element via the low thermal resistance path, such that the heat capacity of the heating element 202 is increased. Therefore, in a case that the temperature of the heating element rises rapidly due to a large transient loss, the rate at which the temperature of the heating element rises is reduced, such that the temperature of the heating element at the end of the peak condition in a short period of time is lowered, thereby ensuring reliability of the power conversion apparatus. In addition, it is unnecessary to adopt a switch transistor with high performance or connect more switch transistors in parallel as in the conventional technology. Therefore, the size, the weight and costs of the system are reduced.

## BRIEF DESCRIPTION OF THE DRAWINGS

In order to more clearly describe the technical solutions in the embodiments of the present disclosure or the technical solutions in the conventional technology, drawings to be used in the description of the embodiments of the present disclosure or the conventional technology are briefly described hereinafter. It is apparent that the drawings described below illustrate merely some embodiments of the present disclosure, and those skilled in the art may obtain other drawings based on the structures shown in the drawings without any creative effort.

Figure 1 is a schematic diagram illustrating a heating element to a heat dissipation device in cross-section according to the conventional technology;

Figure 2 is a schematic diagram illustrating a power conversion apparatus in cross-section according to an embodiment of the present disclosure;

Figure 3 illustrates a top view of a heating element according to an embodiment of the present disclosure;

Figure 4 is a top view illustrating multiple heating elements soldered on a printed circuit board according to an embodiment of the present disclosure;

Figure 5 is a schematic diagram illustrating an additional high heat capacity device arranged around a low thermal resistance path in cross-section according to an embodiment of the present disclosure;

Figure 6 is a top view illustrating the additional high heat capacity device implemented by a copper block according to an embodiment of the present disclosure;

Figure 7 is a top view illustrating the additional high heat capacity device implemented by a copper trip according to an embodiment of the present disclosure;

Figure 8 is a top view illustrating the additional high heat capacity device implemented by a U-shaped copper trip according to an embodiment of the present disclosure; and

Figure 9 is a schematic diagram illustrating, by curves, comparison in temperature between the power conversion apparatus according to the embodiment of the present disclosure and a system with no additional high heat capacity device.

## DETAILED DESCRIPTION OF EMBODIMENTS

Technical solutions in the embodiments of the present disclosure are clearly and completely described below with reference to the drawings in the embodiments of the present disclosure. It is apparent that the embodiments described in the following are only some rather than all of the embodiments of the present disclosure. Any other embodiments obtained by those skilled in the art based on the embodiments in the present disclosure without any creative work fall within the protection scope of the present disclosure.

In the present disclosure, terms "include", "comprise" or any other variants thereof are intended to be non-exclusive. Therefore, a process, method, article or device including a series of elements includes not only these elements but also elements that are not enumerated, or elements that are inherent to the process, method, article or device. Unless expressively limited otherwise, an element limited by "comprising/including a(n) ..." does not exclude existence of another identical element in the process, method, article or device including the element.

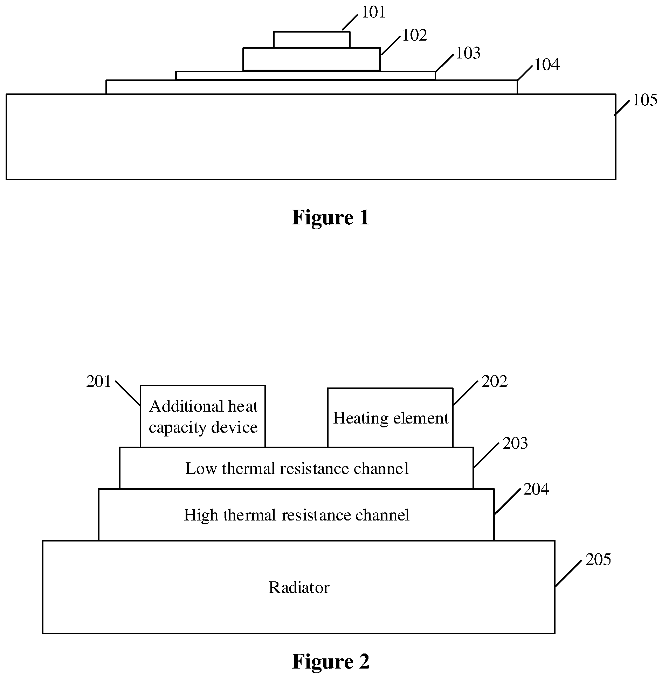

Figure 1 is a schematic diagram illustrating a heating element to a heat dissipation device in cross-section according to the conventional technology. A heating element 101 inevitably generates a large amount of heat in a short period of time (for example, tens of seconds) in order to meet an output condition at a peak, that is, an output capacity several times higher than that at the rated condition. In this case, the heat is transferred to a heat dissipation device 105 through a semiconductor lead frame 102, a PCB (Printed Circuit Board) surface copper foil 103 and a PCB insulating layer 104 in sequence. However, due to the fact that the overall heat capacity of the system is small and the thermal conductivity of the PCB insulating layer 104 is poor, the heat dissipation device 105 fails to achieve a good heat dissipation effect, resulting in a sharp rise in temperature of the heating element 101, which has a great impact on the system.

There is a problem that the system is large in size and weight, and has high costs existing in all of the above existing technical solutions such as adopting the switch transistor with high performance or connecting multiple switch transistors in parallel or adopting the heat dissipation device with high heat dissipation capacity. Therefore, a power conversion apparatus is provided according to the present disclosure, to solve the problem of large size, large weight and high costs of the system existing in the conventional technology.

Figure 2 schematically illustrates the apparatus in cross-section. The power conversion apparatus includes: a low thermal resistance path 203, a high thermal resistance path 204, a heatsink 205, an additional high heat capacity device 201 and at least one heating element 202. The additional high heat capacity device 201 is connected to the at least one heating element 202 via the low thermal resistance path 203. The heatsink 205 is connected to the at least one heating element 202 via the high thermal resistance path 204.

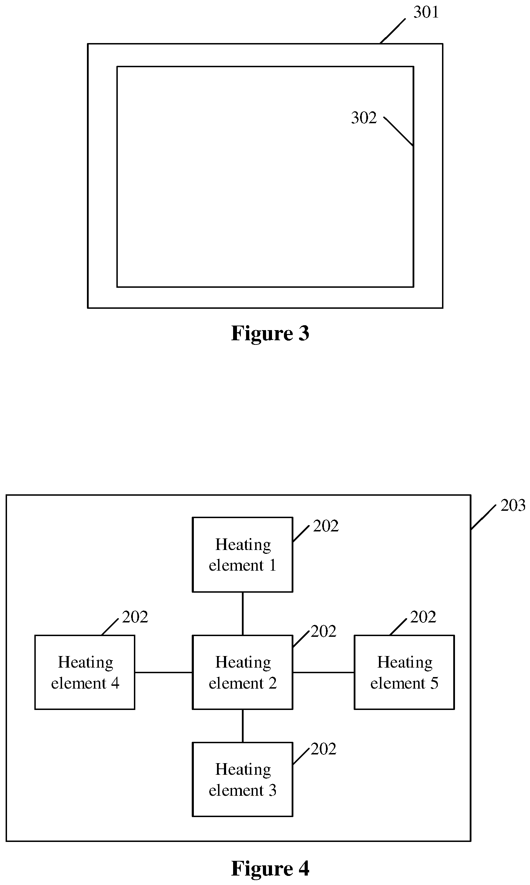

It should be noted that this embodiment is described by an example in which the power conversion apparatus includes one heating element 202. Figure 3 illustrates a top view of the heating element 202. The heating element 202 includes a power device chip 302 arranged on a chip lead frame 301. The chip lead frame 301 is generally implemented by a DBC (Direct Bonded Copper) board. The power device chip 302 is soldered on one side of the chip lead frame 301, and then the power device chip 302 and the chip lead frame 301 are packaged by using materials such as epoxy to form a device. Due to the limitation of industrial packaging standards, the power device chip 302 is generally small in size, and the chip lead frame 301 is also generally small in size on which a size of the packaged device depends.

In practice, the low thermal resistance path 203 is made of one kind of metal or multiple kinds of metal, for example, a surface metal of the PCB (including an aluminum substrate) and solder for the surface metal. The surface metal of the PCB is generally made of copper foil. Since the copper is prone to oxidation in common environment, it is impossible to apply tin on the surface metal (of poor solderability). Therefore, the copper surface is protected by processes such as hot air solder leveling (HASL), electroless nickel immersion gold (ENIG), immersion silver, immersion tin, and organic solderability preservative (OSP). These processes are not limited herein. The chip lead frame 301 soldered with the heating element 202 is soldered to the copper foil printed on the PCB at the other side of the chip lead frame 301. In many application scenarios, since one apparatus generally includes various power device chips 302 to implement their respective functions, multiple heating elements 202, for example, a heating element 1 to a heating element 5 in Figure 4, are generally soldered to the copper foil printed on the PCB. The multiple heating elements 202 form a power conversion circuit, by soldering and wiring, on the copper foil printed on the PBC. The power conversion circuit may be an ACDC conversion circuit, a DCAC conversion circuit, a DCDC conversion circuit, or an ACAC conversion circuit, depending on application scenarios. For a PCB provided with multiple heating elements 202, the additional high heat capacity device 201 is arranged in a manner similar to that in the case of only one heating element 202. The additional high heat capacity device 201 may be implemented as a whole or as multiple separate elements, which is not limited herein. In general, the copper foil on the PCB is of tens of microns in thickness, and is small in area for the sake of power density, and thus is small in size.

That is, the heating element 202 itself is small in size, and the low thermal resistance path 203 is also small in size, leading to a relatively low overall heat capacity of the system.

In addition, the high thermal resistance path 204 includes at least one insulating layer, which may actually be an insulating layer in the aluminum substrate and the heat conductive silicone grease and the like. It is well known that the insulating layer and the heat conductive silicone grease each have low thermal conductivity, even less than one percent of the metal for the chip lead frame 301, the PCB and the like. In addition, the insulating layer generally has a certain thickness in order to ensure insulation performance and processing performance (for example, anti-breakage or anti-cracking) of the insulating layer.

In a case that the heating element 202 of small heat capacity is arranged on the low thermal resistance path 203, and then the low thermal resistance path 203 is arranged on the heatsink 205 via the high thermal resistance path 204, the heating element 202 generates a large amount of heat in response to a large amount of power consumption in a short period of time. In this case, on the one hand the heat is transferred to the heatsink 205 through the high thermal resistance path 204, and on the other hand the heat is shared between the heating element 202 and the PCB. However, the overall heat capacity is small and the rate at which the heat is transferred to the heatsink 205 through the high thermal resistance path 204 is slow, inevitably resulting in a sharp rise in temperature of the heating element 202, thereby affecting the reliability of the apparatus.

In view of this, the additional high heat capacity device 201 is connected to the heating element 202 though the low thermal resistance path 203. The additional high heat capacity device 201 is large in size, leading to an increase in heat capacity of the heating element 202. Therefore, the rise in temperature of the heating element 202 is slowed down in a case that the power device chip 302 causes a large amount of power consumption in a short period of time.

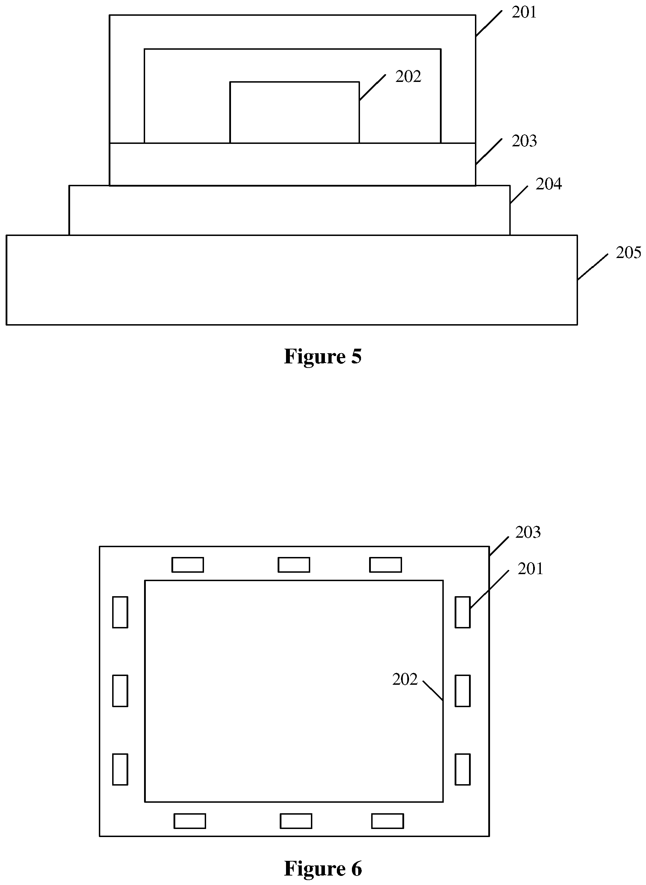

Referring to Figure 5, the additional high heat capacity device 201 is connected to the heating element 202 via the low thermal resistance path 203. The solution that the additional high heat capacity device 201 is arranged on the PCB and around the heating element 202 and the solution that the additional high heat capacity device 201 is interspersed among multiple heating elements 202 are all within the protection scope of the present disclosure. In addition, the additional high heat capacity device 201 is generally made of metal with relatively high thermal conductivity, including but not limited to copper or aluminum. Any solution that the additional high heat capacity device 201 is made of material with thermal conductivity greater than that of the high thermal resistance path 204 is within the protection scope of the present disclosure. In an application scenario where the power device chip 302 is soldered to an aluminum substrate or a copper foil, a metal of high heat capacity is soldered on the edge of the copper foil to reduce the instantaneous rise in temperature.

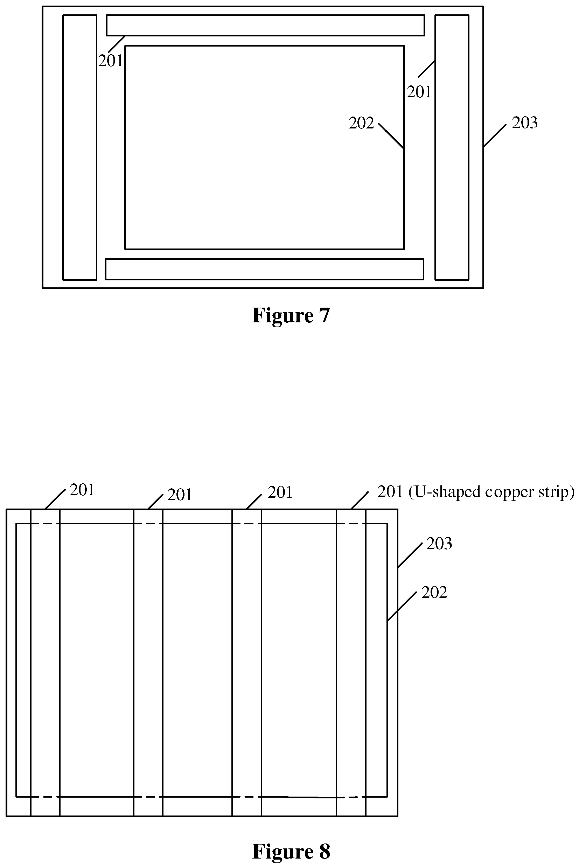

In addition, referring to Figure 6 and Figure 7,the additional high heat capacity device 201 may be in the shape of a strip or a block. Figure 6 is a top view illustrating the additional high heat capacity device 201 in the shape of a block and Figure 7 is a top view illustrating the additional high heat capacity device 201 in the shape of a strip. It can be seen that the additional high heat capacity device 201 in the shape of either the strip or the block may be arranged around the heating element 202 (as shown in Figure 6 and Figure 7) or interspersed among multiple heating elements 202 (not shown). In addition, in a case that the additional high heat capacity device 201 is in the shape of a strip, the additional high heat capacity device 201 is in the shape of a U-shaped strip. Figure 8 is a top view illustrating the additional high heat capacity device 201 in the shape of a U-shaped strip. The additional high heat capacity device 201 in the shape of a U-shaped strip is soldered on the copper foil printed on the PCB with the opening facing down, straddling the heating element 202, as shown in Figure 5 in cross-section. Figure 6 to Figure 8 each illustrate an example in which the number of the additional high heat capacity device 201 is multiple. In practice, the power conversion apparatus may include one additional high heat capacity device 201, which is not limited herein. One or more copper blocks or copper strips may be arranged depending on application scenarios, which are all within the protection scope of the present disclosure. However, regardless of its number, shape, position or material, the additional high heat capacity device 201 is soldered on the copper foil printed on the PCB board for the following reasons. On the one hand, the chip lead frame 301 to which the heating element 202 is soldered is small in size, and has no room for the additional high heat capacity device 201. On the other hand, the additional high heat capacity device 201 being soldered to the chip lead frame 301 inevitably results in an increase in size and weight of the heating element 202, which is not in line with the original intention of the present disclosure.

Only some examples of the additional high heat capacity device 201 are described above, and the present disclosure is not limited thereto. The additional high heat capacity device 201 in any shape that increasing the heat capacity of the heating element 202 is within the protection scope of the present disclosure. A copper strip or a copper block is soldered on the copper foil printed on the PCB and around the power component chip 302, such that the temperature at the peak is reduced.

Further, the operation principle of the additional high heat capacity device 201 is explained based on the following formula for heat energy and formula for thermal conduction.

The formula for thermal energy is expressed as $q = cm\Delta T$.

q represents absorbed or released thermal energy (J). c represents the specific heat capacity of the material (J/(kg.°C)). m represents mass of the material (kg). $\Delta T$ represents a difference in temperature (°C). It can be seen that in order to reduce the rate at which the temperature of an object rises in a case that absorbed heat energy is identical to the released heat energy, the specific heat capacity and the mass of the material that the object is made of are increased.

The formula for heat conduction is expressed as $Q = -\lambda A \frac{\partial t}{\partial x}$;

Q represents the heat conduction flow (W). $\lambda$ represents thermal conductivity (W/m.°C) of the material. A represents the cross-sectional area (m²) perpendicular to the direction of heat transfer. $\frac{\partial t}{\partial x}$ represents a temperature gradient (°C/m) along a normal line to the isothermal surface. The negative sign in the formula indicates that the direction of heat transfer is opposite to the temperature gradient. It can be seen that in order to increase the amount of heat dissipated through heat transfer, the thermal conductivity of the material is increased. For example, a material with high thermal conductivity (copper or aluminum) is selected. Alternatively, a cross-sectional area of the additional high heat capacity device 201 in the direction of heat transfer is increased.

In the power conversion apparatus according to the present disclosure, the additional high heat capacity device is connected to the heating element via the low thermal resistance path, such that the heat capacity of the heating element 202 is increased. Therefore, in a case that the temperature of the heating element rises rapidly due to a large transient loss, the rate at which the temperature of the heating element rises is reduced, such that the temperature of the heating element at the end of the peak condition in a short period of time is lowered, thereby ensuring the reliability of the power conversion apparatus. In addition, it is unnecessary to adopt a switch transistor with high performance or connect more switch transistors in parallel as in the conventional technology. Therefore, the size, the weight, and costs of the system are reduced.

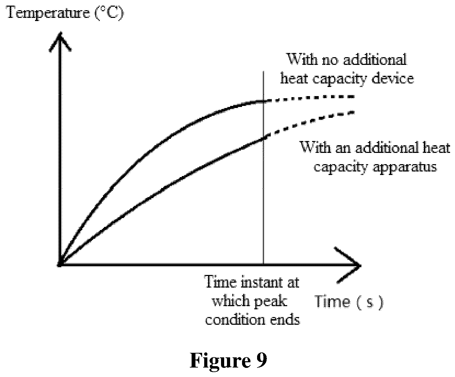

Referring to Figure 9, the power conversion apparatus with an additional heat capacity apparatus 201 according to this embodiment of the present disclosure has a significant effect on reducing the rate at which the temperature of the system rises in a case that the temperature of the heating element 202 rises rapidly due to a large transient loss. A starting point of the curve indicates that the temperature of the heating element 202 begins to rise rapidly. It can be seen that the temperature of the system with no additional high heat capacity device or other better heat dissipation device in the conventional technology rises rapidly. The rate at which the temperature of the system with an additional high heat capacity device according to this embodiment rises is significantly lower than that of the system with no additional high heat capacity device. In addition, at the end of the peak condition, the temperature of the system with an additional high heat capacity device is also significantly lower than that of the system with no additional high heat capacity device, which proves the rationality and feasibility of the system with an additional high heat capacity device and ensures the reliability of the system.

It should be noted that, there are following solutions in the conventional technology to the operation condition of large power consumption of the system due to the peak output in a short period of time. For example, a switch transistor with a high performance is adopted or multiple switch transistors are connected in parallel in the system to reduce the peak power consumption of the system, thereby reducing the rate at which the temperature of the heating component rises. Alternatively, a material with high thermal conductivity, such as an aluminum substrate and a heat conductive silicone grease is selected to accelerate the transfer of the heat generated by the heating element to the heatsink. Alternatively, a heat dissipation device with high heat dissipation capacity is arranged to reduce the temperature of the system itself.

It can be seen that in all the technical solutions existing in the conventional technology, a margin by which the temperature of the system rises in the rated condition is increased, so as to solve the problem that the temperature of the system rises rapidly due to a sharp rise in temperature of the heating element in order to meet the peak condition in a short period of time.

In addition, the above technical solutions have the same drawbacks. The adopting a switch transistor with high performance or connecting multiple switch transistors in parallel inevitably results in an increase in costs of the heating element itself. Further, connecting multiple switch transistors in parallel inevitably results in an increase in size of the PCB board. Selecting a material with high thermal conductivity or adopting a heat dissipation device with high heat dissipation capacity also results in high costs, and even results in an increase in the size and weight of the heat dissipation device. In summary, the system according to the above conventional solutions is large in size and weight, and has high costs.

In the power conversion apparatus according to the embodiments of the present disclosure, an additional high heat capacity device 201 is arranged on the low thermal resistance path 203, such that the heat capacity of the heating element 202 is increased, thereby increasing the ability of the heating element 202 to store heat at the peak condition without changing the rise in the temperature in the rated condition. In addition, no change is made to the heating element or the heat dissipation device, leading to no increase in the size or weight as well as the costs of the system.

The embodiments in this specification are described in a progressive manner, the same or similar parts among the embodiments may be referred to each other, and each of the embodiments emphasizes the differences between the embodiment and other embodiments. In particular, since the system or the embodiment of the system is similar to the embodiment of the method, the description of the system or the embodiment of the system is simple, and reference may be made to the relevant part of the embodiment of the method. The above-described system and the embodiment of the system is only illustrative. Units described as separated components may be physically separated or not. Components shown as units may be physical units or not, i.e. may be located in one place or may be distributed onto multiple network units. Some or all modules thereof may be selected as required to implement the solution in the embodiments. Those skilled in the art can understand and implement the embodiments without any creative work.

Those skilled in the art should further noted that, units and algorithm steps of examples described in conjunction with the embodiments disclosed herein may be implemented by electronic hardware, computer software or a combination thereof. In order to clearly illustrate interchangeability of the hardware and the software, steps and elements of each embodiment have been described generally in terms of functions in the above specification. Whether these functions are implemented in hardware or software depends on the specific application and design constraints for the technical solution. Those skilled in the art may implement the described functions for each particular application in various manners, and such implementation should not be regarded as going beyond the scope of the present disclosure.

The disclosed embodiments are disclosed above, so that those skilled in the art may implement or use technical solutions of the present disclosure. Those skilled in the art will easily think of various modifications to the embodiments, and general principles defined in the present disclosure may be implemented in other embodiments without departing from the spirit or scope of the present disclosure. Therefore, the present disclosure is to be accorded the widest scope consistent with the principles and novel features disclosed herein rather than intended to be limited to the embodiments described herein.

**Claims**

1. A power conversion apparatus, comprising: a low thermal resistance path, a high thermal resistance path, a heatsink, an additional high heat capacity device, and at least one heating element, wherein

   the additional high heat capacity device is connected to the at least one heating element via the low thermal resistance path; and
   the heatsink is connected to the at least one heating element via the high thermal resistance path.

2. The power conversion apparatus according to claim 1, wherein the low thermal resistance path is made of one kind of metal or a plurality of kinds of metal.

**3.** The power conversion apparatus according to claim 1, wherein the additional high heat capacity device is made of metal.

**4.** The power conversion apparatus according to claim 3, wherein the additional high heat capacity device is made of copper or aluminum.

**5.** The power conversion apparatus according to any one of claims 1 to 4, wherein the additional high heat capacity device is in a shape of a strip or a block.

**6.** The power conversion apparatus according to any one of claims 1 to 4, wherein

the additional high heat capacity device is arranged around the at least one heating element; or
the additional high heat capacity device is arranged to straddle the at least one heating element.

**7.** The power conversion apparatus according to any one of claims 1 to 4, wherein each of the at least one heating element comprises a power device chip arranged on a chip lead frame.

**8.** The power conversion apparatus according to any one of claims 1 to 4, wherein the low thermal resistance path is formed by a surface metal of a PCB and solder for the surface metal, and a plurality of heating elements form a power conversion circuit on the PCB.

**9.** The power conversion apparatus according to claim 8, wherein the power conversion circuit is an ACDC conversion circuit, a DCAC conversion circuit, a DCDC conversion circuit or an ACAC conversion circuit.

**10.** The power conversion apparatus according to any one of claims 1 to 4, wherein the high thermal resistance path comprises at least one insulating layer.

101

102

103

104

105

**Figure 1**

201

Additional heat
capacity device

Heating element

202

Low thermal resistance channel

203

High thermal resistance channel

204

Radiator

205

**Figure 2**

301

302

**Figure 3**

203

202

Heating
element 1

202

Heating
element 4

202

Heating
element 2

202

Heating
element 5

202

Heating
element 3

**Figure 4**

201

202

203

204

205

**Figure 5**

203

201

202

**Figure 6**

**Figure 7**

**Figure 8**

**Figure 9**

## INTERNATIONAL SEARCH REPORT

| International application No. |
|---|
| **PCT/CN2021/094057** |

**A.    CLASSIFICATION OF SUBJECT MATTER**

H02M 1/00(2007.01)i;  H05K 7/20(2006.01)i

According to International Patent Classification (IPC) or to both national classification and IPC

**B.    FIELDS SEARCHED**

Minimum documentation searched (classification system followed by classification symbols)

H02M; H05K

Documentation searched other than minimum documentation to the extent that such documents are included in the fields searched

Electronic data base consulted during the international search (name of data base and, where practicable, search terms used)

CNABS; CNTXT; CNKI; SIPOABS; DWPI; USTXT; WOTXT; EPTXT: 热容, 热熔, 金属, 铜, 铝, 芯片, 热量, 发热, 散热, 热沉, 降温, 温度, 印刷电路板, PCB, 引线框架, DBC, heat, capacity, metal, copper, aluminum, chip, radiator, sink, thermal, temperature

**C.    DOCUMENTS CONSIDERED TO BE RELEVANT**

| Category* | Citation of document, with indication, where appropriate, of the relevant passages | Relevant to claim No. |
|---|---|---|
| PX | CN 211908640 U (SUNGROW POWER SUPPLY CO., LTD.) 10 November 2020 (2020-11-10) <br> claims 1-10 | 1-10 |
| X | CN 103745962 A (UNITED AUTOMOTIVE ELECTRONIC SYSTEMS CO., LTD.) 23 April 2014 (2014-04-23) <br> description, paragraphs [0046]-[0061], and figures 4-8 | 1-10 |
| X | CN 101438403 A (TOSHIBA K. K.) 20 May 2009 (2009-05-20) <br> description page 7 line 14 - page 9 line 16, figures 3-5 | 1-10 |
| A | CN 102842543 A (DENSO CORPORATION) 26 December 2012 (2012-12-26) <br> entire document | 1-10 |
| A | CN 101165884 A (INFINEON TECHNOLOGIES AG) 23 April 2008 (2008-04-23) <br> entire document | 1-10 |

☐ Further documents are listed in the continuation of Box C.     ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **14 July 2021** | **04 August 2021** |

| Name and mailing address of the ISA/CN | Authorized officer |
|---|---|
| **China National Intellectual Property Administration (ISA/ CN)** <br> **No. 6, Xitucheng Road, Jimenqiao, Haidian District, Beijing 100088** <br> **China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2021/094057**

| Patent document cited in search report | | | Publication date (day/month/year) | Patent family member(s) | | | Publication date (day/month/year) |
|---|---|---|---|---|---|---|---|
| CN | 211908640 | U | 10 November 2020 | None | | | |
| CN | 103745962 | A | 23 April 2014 | CN | 103745962 | B | 10 May 2017 |
| CN | 101438403 | A | 20 May 2009 | JP | 2007305702 | A | 22 November 2007 |
| | | | | US | 2009237890 | A1 | 24 September 2009 |
| | | | | EP | 2020683 | A4 | 13 October 2010 |
| | | | | WO | 2007129486 | A1 | 15 November 2007 |
| | | | | EP | 2020683 | A1 | 04 February 2009 |
| CN | 102842543 | A | 26 December 2012 | US | 2012326292 | A1 | 27 December 2012 |
| | | | | JP | 2013004953 | A | 07 January 2013 |
| CN | 101165884 | A | 23 April 2008 | DE | 102007046021 | B4 | 13 September 2012 |
| | | | | US | 2008093729 | A1 | 24 April 2008 |
| | | | | CN | 100573859 | C | 23 December 2009 |
| | | | | US | 8164176 | B2 | 24 April 2012 |
| | | | | DE | 102007046021 | C5 | 14 July 2016 |
| | | | | DE | 102007046021 | A1 | 21 May 2008 |

Form PCT/ISA/210 (patent family annex) (January 2015)

14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202020837107